# EUROPÄISCHE PATENTANMELDUNG

(11) **EP 2 477 285 A1**
(43) Veröffentlichungstag der Anmeldung: **18.07.2012**
(21) Anmeldenummer: 11164777.2
(22) Anmeldetag: 04.05.2011
(51) Int. Cl.: H01S 5/40, H01S 5/022, H01S 5/024, H01S 5/14, H01S 5/02

(54) **Laserdiodenbarren und Lasersystem**

(30) Priorität: 18.01.2011 CH 982011
(71) Anmelder: Bystronic Laser AG, 3362 Niederönz (CH)
(72) Erfinder: Lüdi, Andreas, 3400, Burgdorf (CH)
(74) Vertreter: Patentbüro Paul Rosenich AG

(57) **Zusammenfassung**

Die Erfindung betrifft eine Laserdiodenanordnung, insbesondere ein Laserdiodenbarren (1), mit einer Trägermatrix (3) und mit in der Trägermatrix (3) eingebetteten, entlang einer Richtung (R) nebeneinander aufgereihten Laserdioden (2), die jeweils im Wesentlichen in Form von Plättchen ausgebildet sind, wobei die auf einer Seite der Laserdiodenanordnung liegenden Stirnflächen der Laserdioden (2) Laserlicht-Austrittsflächen (4) mit einer Längsausdehnung (L) sind.Die Laserdioden (2) sind dabei zur Verbesserung der Brillanz derart ausgerichtet , dass die Längsausdehnungen (L) ihrer Laserlicht-Austrittsflächen (4) zur Richtung (R), entlang derer die Laserdioden (2) aufgereiht sind, geneigt sind. Dadurch wird die Qualität beim Laser-Schneiden verbessert.

## Beschreibung

Die Erfindung bezieht sich auf die Erzeugung von Laserstrahlen hoher Leistung und hoher Brillanz (High-Brightness-Laser), insbesondere für den Einsatz in Laserbearbeitungsmaschinen, insbesondere zum Schneiden und Bearbeiten von Werkstücken. Die Erfindung bezieht sich ebenfalls auf einen Laserdiodenbarren bzw. eine Laserdiodenanordnung umfassend mehrere, in einer Trägermatrix eingebettete Laserdioden und auf ein Lasersystem zur Erzeugung eines Lasersystem-Ausgangsstrahls.

Im speziellen bezieht sich die Erfindung auf eine Laserdiodenanordnung, insbesondere einen Laserdiodenbarren, mit einer Trägermatrix und mit in der Trägermatrix eingebetteten, entlang einer Richtung nebeneinander aufgereihten Laserdioden, die jeweils im Wesentlichen in Form von Plättchen ausgebildet sind, wobei die auf einer Seite der Laserdiodenanordnung liegenden Stirnflächen der Laserdioden Laserlicht-Austrittsflächen mit einer Längsausdehnung sind.

Die Erfindung bezieht sich weiter auf eine Laserdiodenanordnung mit einer Trägermatrix und mit in der Trägermatrix eingebetteten, nebeneinander angeordneten Laserdioden, die Laserlicht-Austrittsflächen aufweisen.

Die Materialbearbeitung mit Hilfe eines Lasers ist lange Zeit bekannt. Dabei wird ein hochenergetischer Lichtstrahl auf ein Material gerichtet, welcher dieses aufschmilzt, verdampft und/oder verbrennt. Auf diese Weise können Materialien einerseits getrennt (Laserschneiden) aber auch zusammengefügt (Laserschweissen) werden. Zu diesem Zweck werden z.B. CO2-Laser, Scheibenlaser, Nd:YAG-Laser, Faserlaser und in letzter Zeit auch Diodenlaser eingesetzt.

Die DE 198 39 482 A1 offenbart dazu ein Materialbearbeitungssystem mittels Hochleistungsdiodenlaser, insbesondere zum Schweißen, Oberflächenreinigen, Auftragsschweißen, Schneiden, Bohren, Gravieren und dgl. Systemkomponenten sind im Wesentlichen ein einhandgeführter Bearbeitungskopf für einen Hochleistungsdiodenlaser, eine Laserquelle, die Stromversorgung mit Regelung und eine Sicherheitssensorik, weiterhin apparative Maßnahmen bzw. Anordnungen zum Strahlungsschutz, zur Abstandsregulierung und Leistungssteuerung über die Bearbeitungsgeschwindigkeit.

Die DE 198 59 243 A1 offenbart weiterhin eine Anordnung zum Schweißen, Schneiden, Bohren oder Beschichten mit einer Zweistrahlquelle und die Verwendung von Laserstrahlen zum Schweißen, Schneiden, Bohren oder Beschichten von metallischen oder nichtmetallischen Stoffen. Die Anordnung besteht aus einer Licht emittierenden Pumpquelle, vorzugsweise einem Diodenlaser oder einer Halogenlampe, und daran optisch angekoppelt einer Lichtleitfaser oder einem Laserstab.

Ausserdem offenbart die DE 10 2008 053 397 A1 ein Verfahren zum Schmelzschneiden von Werkstücken mit Laserstrahlung. Dabei wird bei vorgegebener Werkstückdicke eine maximale Absorption der Laserstrahlung erreicht, indem der Neigungswinkel der Schneidfront durch eine Anpassung der Geometrie eines Laserstrahls mittels Strahlformung und/oder einer der Vorschubbewegung überlagerten Bewegung des Brennpunktes des Laserstrahls verändert wird.

Zwar verfügen die bekannten Laserbearbeitungsmaschinen über eine ausreichende Leistung des Diodenlasers, aufgrund der beschränkten Strahlqualität jedoch nicht über eine ausreichende Leistungskonzentration. Zudem geht die im Stand der Technik offenbarte Lehre nicht auf die Asymmetrie des vom Diodenlaser emittierten Laserstrahls ein. Die natürliche asymmetrische Strahlung eines Diodenlasers weist ja in einer ersten transversalen Richtung eine vergleichsweise gute Strahlqualität (d.h. ein kleines Strahlparameterprodukt) auf, in die dazu orthogonale zweite transversale Richtung dagegen eine vergleichsweise schlechte Strahlqualität (d.h. ein grosses Strahlparameterprodukt).

Es sind auch Lösungen bekannt, um den asymmetrischen Laserstrahl eines Diodenlasers zu symmetrisieren, sodass die Strahlqualität und die Ausbreitungscharakteristik in alle transversalen Richtungen mehr oder minder gleich sind. Beispielsweise kann eine solche Symmetrisierung mittels Treppenspiegel oder Redirectors gemacht werden oder auch in einer kreisrunden Faser stattfinden, durch die der Laserstrahl geleitet wird. Leider geht damit eine Verschlechterung der an sich guten Strahlcharakteristik in der ersten transversalen Richtung einher, sodass nach dem Stand der Technik nur unbefriedigende Schnittergebnisse erzielt werden konnten, beziehungsweise die wegen des großen Brennflecks erforderliche Laserleistung vergleichsweise hoch und zum Teil nicht realisierbar ist. Zudem wird normalerweise die Polarisationscharakteristik des Diodenlasers in einer herkömmlichen Faser verändert. Im Endergebnis sind Diodenlaser nach dem Stand der Technik nur bedingt zum Schneiden geeignet.

Darüber hinaus offenbart die JP 6320296 A eine Laserbearbeitungsmaschine zum Bohren von Löchern, bei welcher ein Laserstrahl einerseits um seine Achse, gleichzeitig aber auch entlang einer kreisförmigen Bahn bewegt wird. Die beiden Bewegungen sind zueinander synchron, sodass die Hauptachse eines asymmetrischen Strahlprofils tangential zu der besagten Kreisbahn ausgerichtet ist. Die JP 6320296 A geht jedoch nicht auf die spezielle Problematik beim Laserschneiden mit Hilfe von Diodenlaser ein. Ausserdem ist die Maschine nicht universell einsetzbar, da bloss kreisrunde Ausschnitte hergestellt werden können. Zudem führt die lange Transmissionsstrecke im absorbierenden Prismenmaterial bei hohen Leistungen zu enormen Leistungsverlusten und im Umkehrschluss zu erheblichen thermisch verursachten Strahl- und Prozessschwankungen. Schließlich ist nach der JP 6320296 A eine Verschiebung der Strahlachse nötig, was die Laserbearbeitungsmaschine technisch aufwändig und damit fehleranfällig macht.

Schliesslich offenbart die US 2009/045176 A1 eine weitere Laserbearbeitungsmaschine zum Bohren von Löchern, bei welcher ein Laserstrahl einerseits um seine Achse, gleichzeitig aber auch entlang einer kreisförmigen Bahn bewegt wird. Auch die US 2009/045176 A1 geht nicht auf die spezielle Problematik beim Laserschneiden mit Hilfe von Diodenlaser ein, ist ebenfalls bloss zum Schneiden kreisrunder Ausschnitte geeignet und ähnlich aufwändig und fehleranfällig wie die JP 6320296 A.

Die Verwendung von Laserdioden im Mittel- und Hochleistungsbereich konnte sich aufgrund der verhältnismäßig geringen Brillanz bis jetzt in vielen Bereichen noch nicht durchsetzen. Um aus Laserdioden einen brauchbaren Laserstrahl zu erhalten, waren die Bemühungen im Stand der Technik bislang darauf ausgerichtet, die einzelne Laserdiode an sich zu verbessern, um bessere Strahlqualitäten (runder, symmetrischer bzw. kleiner Querschnitt, bessere Fokussierung, bessere Wellenlängenstabilität, mehr Leistung, größere Brillanz, etc.) zu erhalten. Die Brillanz wird im Zusammenhang mit Lasern oft als deskriptive, nicht-quantitative Größe verwendet und bezieht sich auf das Maß der Bündelung eines Strahls. Manchmal wird der Begriff Brillanz auch in quantitativer Hinsicht verwendet, wobei in der Literatur leicht voneinander abweichende Definitionen zu finden sind. Üblicherweise wird die Brillanz als Maß für die Leistung pro Fläche und Rauwinkel definiert und besitzt die Einheit [W cm⁻² sr⁻¹] mit sr für den steradiant.

Erst seit kurzem wird ein Hauptaugenmerk der Entwicklung darauf gelegt, das Zusammenwirken mehrerer Laserdioden derart zu optimieren, dass ein resultierender Ausgangsstrahl entsteht, der im Wesentlichen ähnliche Strahleigenschaften aufweist wie eine einzelne Diode, jedoch wesentlich höhere Leistung und Leuchtdichte aufweist. Gleichzeitig sollen dabei die geometrischen und Wellenlängen-Eigenschaften von Laserlicht erhalten bleiben. Derartige Ansätze versprechen die Anwendung von Laserdioden auch im Hochleistungsbereich, insbesondere in der Laserbearbeitung von Werkstücken.

In den Dokumenten US 6,208,679 B1, im Online-Artikel (http://www.rp-photonics.com/spectral_beam_combining.html), und im Online-Artikel (http://www.ll.mit.edu/publications/labnotes/brightidea.html) wird ein neues Konzept vorgestellt, wie die einzelnen Strahlen mehrerer Laserdioden zu einem resultierenden Ausgangsstrahl kombiniert werden können. Diese Technologie ist auch unter der Bezeichnung Spectral Beam Combining (oder Wavelength Beam Combining oder Incoherent Beam Combining) bekannt.

Bei dieser Technologie wird ein so genannter Laserdiodenbarren verwendet, der mehrere nebeneinander aufgereihte Laserdioden aufweist, die jeweils in Form von Plättchen ausgebildet sind. Die einzelnen Laserdioden eines Laserdiodenbarrens sind an einen gemeinsamen externen Resonator angekoppelt. Der externe Resonator besteht aus einem optischen Element (z.B. einer Sammellinse), einem Beugungsgitter und einem Auskoppler. Das optische Element richtet die einzelnen Laserdioden-Strahlen auf das Beugungsgitter, an dem eine wellenlängenselektive Ab- bzw. Umlenkung erfolgt. Die vom Beugungsgitter gebeugten Strahlen treffen auf einen Auskoppler (z.B. einen teildurchlässigen Spiegel), von dem ein Teil des Laserlichts über das Beugungsgitter und das optische Element zurück in die Laserdioden gelenkt wird. Das Beugungsgitter bewirkt nun, dass in eine einzelne Laserdiode nur eine ganz spezifische Wellenlänge zurückreflektiert wird, so dass in dieser einzelnen Laserdiode genau jene spezifische Wellenlänge verstärkt wird. Benachbarte Laserdioden können somit unterschiedliche, leicht voneinander abweichende Wellenlängen verstärken. Der Resonator vereinigt diese verschiedenen Wellenlängen ähnlich einem inversen Prisma und stellt am Ausgang des Auskopplers einen Ausgangsstrahl mehrerer Wellenlängen, hoher Qualität, hoher Leistung und hoher Leuchtdichte zur Verfügung.

Diodenbarren (zum Beispiel offenbart auf der Internetseite http://www.rp-photonics.com/diode_bars.html) sind eindimensionale Anordnungen mehrerer Laserdioden (Halbleiter-Laser). Die einzelnen Laserdioden sind in Form von Plättchen ausgebildet, die mit ihrer größten Fläche in einer gemeinsamen Ebene angeordnet sind. Die Laserlicht-Austrittsfläche bildet eine längliche Stirnfläche des Laserdioden-Plättchens. Die Laserlicht-Austrittsfläche einer einzelnen Diode besitzt somit eine Längsausdehnung von beispielsweise 50, 100, 200 µm (Mikrometer). Schmalseite der Laserlicht-Austrittsfläche bewegt sich in der Größenordnung von 1 oder einigen Mikrometern. Diese Geometrie bewirkt, dass die geometrischen Strahleigenschaften einer einzelnen Laserdiode asymmetrisch sind. Dabei unterscheidet man die "fast axis" Richtung, das ist die Richtung entlang der Schmalseite, und die "slow axis" Richtung, das ist die Richtung der Längsausdehnung. Entlang der "fast axis" kann die Stahlqualität im Wesentlichen als beugungsbegrenzt angesehen werden mit einer Beugungsmaßzahl M² von nur wenig über dem Wert 1. Die Divergenz ist jedoch in dieser Richtung hoch.

Im Gegensatz dazu ist die Divergenz entlang der "slow axis" wesentlich geringer. Dafür ist hier die Strahlqualität stark verringert. Die Beugungsmaßzahl M² (sie ist der Reziprokwert der Stahlqualität K) nimmt z.B. für eine Längsausdehnung von 100 µm Werte von etwa 20 an.

Weitere Dokumente zu diesem Themenbereich finden sich u.a. in den folgenden Druckschriften: US 6 192 062 B1, US 2010 0 110 556 A1, WO 2010 053 911 A2, WO 2006 116 477 A2, WO 2007 100 341 A2, WO 2010 096 257 A2, US 6 697 192 B1, US 6 327 292 B1.

Alle in dieser Anmeldung zitierten Druckschriften und Artikel werden durch Bezugnahme in diese Beschreibung aufgenommen.

Es hat sich nun gezeigt, dass die Erzeugung eines gemeinsamen hochqualitativen Ausgangsstrahls aufgrund der unterschiedlichen Eigenschaften der einzelnen Laserdioden und deren Anordnung auf einem Barren (Asymmetrie, Fertigungstoleranzen der Laserdioden, geometrische Anordnung, etc.) nicht einfach ist. Insbesondere die Erzeugung von Hochleistungslaserstrahlen mit für die jeweiligen Anwendungen erforderlichen geometrischen und leistungsbezogenen Eigenschaften kann noch nicht im zufriedenstellenden Ausmaß bewerkstelligt werden. Das Kriterium Platzbedarf spielt ebenso eine wichtige Rolle: Einerseits weil eine Laserquelle im eigentlichen Gerät (z.B. Laserbearbeitungsmaschine) nur einen Teil der Gesamtbauteile darstellt und möglichst wenig Raum beanspruchen darf, andererseits weil die optischen Eigenschaften eines Lasers stark von den geometrischen Gegebenheiten abhängen, wobei Lichtquellen kleiner Ausdehnung in den meisten Fällen zu bevorzugen sind.

Das Ziel der Erfindung besteht insbesondere darin, die Verwendung von Laserdioden im Hochleistungsbereich zur Anwendung zu bringen. Dabei sollen Laserstrahlen hoher Qualität, hoher Leistung und hoher Leuchtdichte zur Verfügung gestellt werden. Platzersparnis und Miniaturisierung ist ein weiteres wichtiges Kriterium und soll positive Auswirkungen auf die Packungsdichte und auf die geometrischen Eigenschaften des Laserstrahls selbst ausüben. Zudem soll eine effiziente Kühlung, hohe Zuverlässigkeit und lange Lebensdauer der Laserdioden und der aus ihnen aufgebauten Laser-Module erreicht werden.

Diese Ziele werden mit einer Laserdiodenanordnung der eingangs genannten Art dadurch erreicht, dass die Laserdioden derart ausgerichtet sind, dass die Längsausdehnungen ihrer Laserlicht-Austrittsflächen zur Richtung, entlang derer die Laserdioden aufgereiht sind, geneigt sind.

Die Neigung der Längsrichtung der Laserlicht-Austrittsflächen zur Richtung, entlang derer die Laserdioden aufgereiht sind, ermöglicht eine optimierte Packungsdichte, die weniger Platz erfordert. Gleichzeitig sind die Flächen größter Ausdehnung von der Trägermatrix vollständig umgeben, die als Wärmesenke aus gut thermisch leitendem Material für die Abfuhr der in der Laserdiode erzeugten Wärme sorgt.

Eine besonders bevorzugte Variante ergibt sich, wenn die Längsausdehnungen der Laserlicht-Austrittsflächen normal auf die Richtung stehen, entlang derer die Laserdioden aufgereiht sind. Dieses Merkmal bewirkt eine optimale Nutzung des vorhandenen Platzes und eine verbesserte Miniaturisierung. Ebenso fällt durch eine derartige Anordnung die Asymmetrie einer einzelnen Laserdiode nicht so stark ins Gewicht.

In einer anderen Ausgestaltung der Erfindung sind die Laserdioden entlang eines geschlossenen Umfangs, insbesondere entlang eines Kreises oder einer Ellipse, angeordnet. Auch hier ergibt sich eine Miniaturisierung bislang nicht gekannten Ausmaßes, wobei die Strahlen gleichzeitig im Zentrum des vom Umfang umschlossenen Gebietes konzentriert werden können.

Im Zusammenhang mit der bereits eingangs beschriebenen Technologie des Spectral Beam Combining kann mit derartigen Laserdiodenanordnungen eine optimale Lösung für Hochleistungsbereiche geschaffen werden. Zwar ist mit der Divergenz entlang der "fast axis" (Schmalseite) und einer erniedrigten Stahlqualität entlang der "slow axis" (Längsausdehnung) grundsätzlich eine Verringerung der Strahlqualität verbunden, jedoch spielt dies insbesondere bei Hochleistungsanwendungen wie der Laserbearbeitung kaum eine Rolle. Oft, insbesondere beim Schneiden, ist ein M² ≈ 20 besser geeignet, als M² ≈ 1

Die Vorteile der Erfindung offenbaren sich nun auch in einem Lasersystem zur Erzeugung eines Lasersystem-Ausgangsstrahls oder eines Laserspots, umfassend mindestens zwei Laser-Module zur Erzeugung von Laser-Modul-Ausgangsstrahlen, wobei die Laser-Module jeweils mindestens eine Laserdiodenanordnung, z.B. einen Laserdiodenbarren, die nebeneinander angeordnete Laserdioden aufweist, und einen externen Resonator, der optisch an die Laserdiodenanordnung angekoppelt ist, umfassen, und wobei das Lasersystem eine Strahlzusammenführungseinrichtung aufweist, die die von den Laser-Modulen erzeugten Laser-Modul-Ausgangsstrahlen zum Lasersystem-Ausgangsstrahl oder Laserspot zusammenführt.

Hier werden in zwei Stufen Laserstrahlen hoher Leistungsdichte erzeugt. In der ersten Stufe werden die Laserstrahlen der einzelnen Laserdioden im externen Laserresonator verstärkt und kombiniert. In der zweiten Stufe erfolgt dann die Zusammenführung mehrerer auf diese Weise (in Laser-Modulen) erzeugter Teilstrahlen mit einer Strahlzusammenführungseinrichtung. Letztere kann z.B. in Form eines halbdurchlässigen Spiegels (dichroitisch oder polarisationsabhängig) oder als Einmündungsstelle mehrerer Einzelfasern in eine gemeinsame Lichtleitfaser ausgebildet sein.

In einer bevorzugten Ausführung sind die einzelnen Laser-Module derart ausgebildet bzw. konfiguriert, dass sich die von ihnen generierten Laser-Modul-Strahlen in ihren Eigenschaften voneinander unterscheiden. D.h. es entstehen gleichzeitig unterschiedliche Laser-Modul-Ausgangsstrahlen. Vorzugsweise sind diese in ihren Eigenschaften nicht überlappend bzw. komplementär.

Das Zusammenführen mehrerer Laserstrahlen unterschiedlicher Eigenschaften (nicht überlappende Spektren und/oder unterschiedliche Polarisation), die zuvor durch Laserdiodenanordnungen erzeugt wurden und bereits entsprechend konditioniert sind, ermöglicht die Erzeugung besonders leistungsstarker Laserstrahlen hoher Leuchtdichte.

Weitere Ausbildungen der Erfindung sind in den Figuren und in den abhängigen Patentansprüchen angegeben.

Die Bezugszeichenliste ist Bestandteil der Offenbarung.

Anhand von Figuren wird die Erfindung symbolisch und beispielhaft näher erläutert. Die Figuren werden zusammenhängend und übergreifend beschrieben. Gleiche Bezugszeichen bedeuten gleiche Bauteile, Bezugszeichen mit unterschiedlichen Indices geben funktionsgleiche oder ähnliche Bauteile an.

Es zeigen dabei
Figur 1 eine Laserdiode in Plättchenform,
Figur 2 einen Laserdiodenbarren gemäß dem Stand der Technik,
Figur 3 einen erfindungsgemäßen Laserdiodenbarren,
Figur 4 ein Lasermodul bestehend aus einem Laserdiodenbarren und einem externen Resonator,
Figur 5 ein erfindungsgemäßes Lasersystem aus zwei Laser-Modulen,
Figur 6 den Transmissionsverlauf eines dichroitischen Spiegels in Abhängigkeit von der Wellenlänge,
Figur 7 ein erfindungsgemäßes Lasersystem aus mehreren Laser-Modulen,
Figur 8 die Einmündung mehrerer Lichtleitfasern in eine gemeinsame Lichtleitfaser,
Figur 9 und 10 Varianten eines erfindungsgemäßen Lasersystems,
Figur 11 eine Laserbearbeitungsmaschine in schematischer Darstellung, und die
Figuren 12 und 13 eine erfindungsgemäße Laserdiodenanordnung.

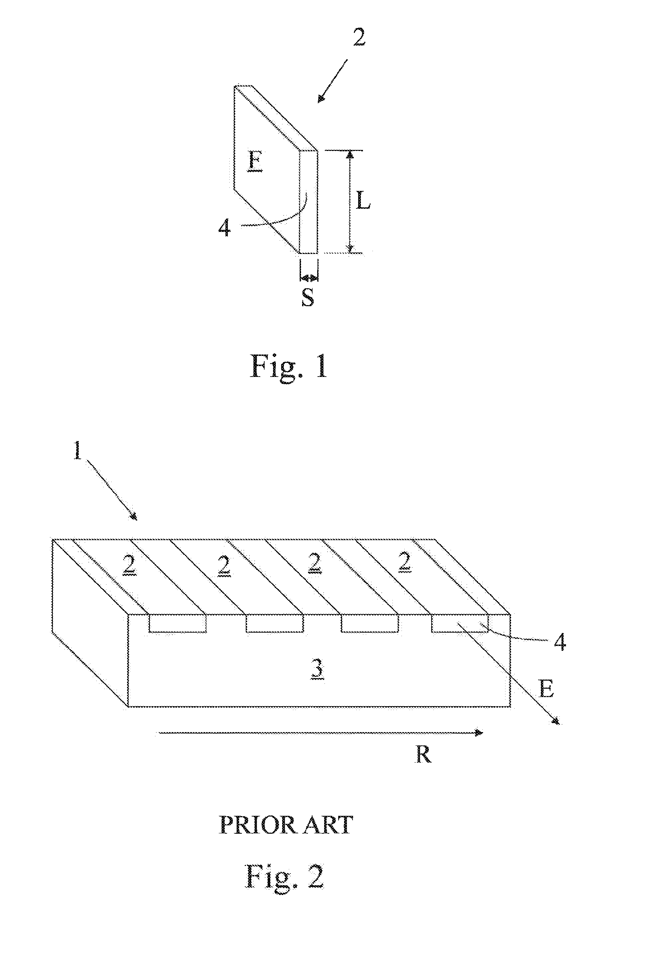

Figur 1 zeigt eine Laserdiode 2 in Form eines Plättchens. Die Laserlicht-Austrittsfläche 4 ist durch eine Stirnfläche des Plättchens mit einer Längsausdehnung L und einer Schmalausdehnung S gebildet. Eine derartige Halbleiterdiode kann elektrisch und/oder optisch gepumpt werden.

Figur 2 zeigt eine Laserdiodenanordnung gemäß dem Stand der Technik in Form eines Laserdiodenbarrens 1. Die einzelnen Laserdioden 2 sind in einer Trägermatrix 3 eingebettet. Die Trägermatrix 3 dient gleichzeitig als Wärmesenke und besteht vorzugsweise aus gut thermisch leitendem Material, um die in den einzelnen Laserdioden 2 erzeugte Wärme effizient abzuleiten. Die Laserdioden-Plättchen sind entlang der Richtung R nebeneinander aufgereiht, wobei die Richtungen der Längsausdehnungen L der Laserlicht-Austrittsfläche 4 parallel zur Richtung R verlaufen. Anders ausgedrückt liegen die Flächen größter Ausdehnung F (siehe Fig. 1) in einer gemeinsamen Ebene. Die Abstrahlrichtung E aus der Laserlicht-Austrittsfläche 4 steht normal zu Richtung R. Wie bereits eingangs erwähnt erfordert eine derartige Anordnung viel Platz in der Richtung R beziehungsweise erlaubt bei vorgegebenen Abmessungen nur eine geringe Anzahl an Laserdioden 2.

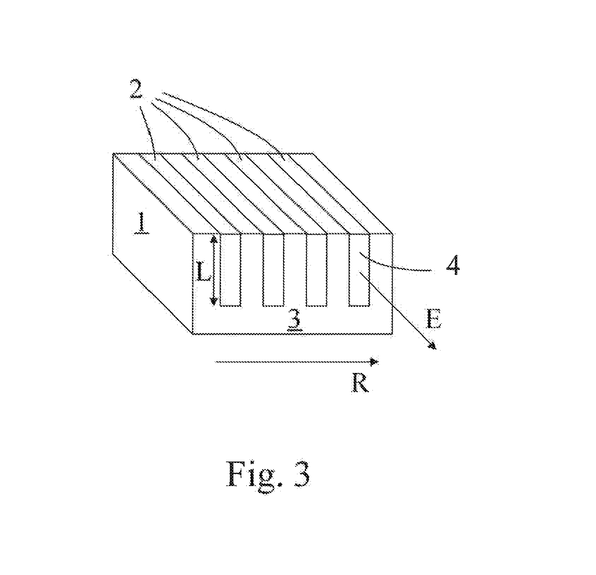

Figur 3 zeigt nun eine erfindungsgemäße Lösung eines Laserdiodenbarrens 1. Im Gegensatz zur Figur 2 sind die plättchenförmigen Laserdioden 2 hochkantig in die Trägermatrix 3 eingesetzt bzw. eingebettet. Anstelle von nur vier Laserdioden 2 könnte auch eine Vielzahl vorgesehen sein. Wie aus der Figur 3 deutlich hervorgeht sind in dieser Ausführungsform die Längsausdehnungen L der Laserlicht-Austrittsflächen 4 zur Richtung R, entlang derer die Laserdioden 2 aufgereiht sind, normal stehend. Diese Maßnahme erlaubt eine höhere Packungsdichte und damit weniger Platzbedarf bzw. ermöglicht bei vorgegebenen Abmessungen eine Packung mehrerer Laserdioden. Ein weiterer Vorteil besteht darin, dass ein Großteil der Außenflächen (insbesondere die Flächen größter Ausdehnung F) einer Laserdiode 2 vom Material der Trägermatrix 3 umgeben sind, so dass ein besserer thermischer Kontakt für eine effizientere Ableitung der Wärme sorgt.

In anderen Varianten der Erfindung könnte die Längsrichtung L zur Richtung R eine andere Neigung als 90° aufweisen, z.B. 45°, 60°, etc. In jedem Fall ergibt sich eine höhere Packungsdichte als im Stand der Technik. Aufgrund der höchsten Packungsdichte und einer einfachen optischen Handhabung wird jedoch die normal stehende Ausrichtung (im Wesentlichen 90°) besonders bevorzugt.

Zum Schneiden braucht es nicht ein M²∼1, sondern beispielsweise ein M²∼20 reicht hier völlig aus. Laserstrahlung aus einer einzelnen Diode mit einer Schmalseiten-Ausdehnung S von typischerweise wenigen µm in x-Richtung und einer Längsausdehnung L von z.B. 100 µm in y-Richtung hat eine Strahlqualität von M²∼1 in x-Richtung, genannt "fast axis", und ein M²∼20 in y-Richtung, genannt "slow axis".

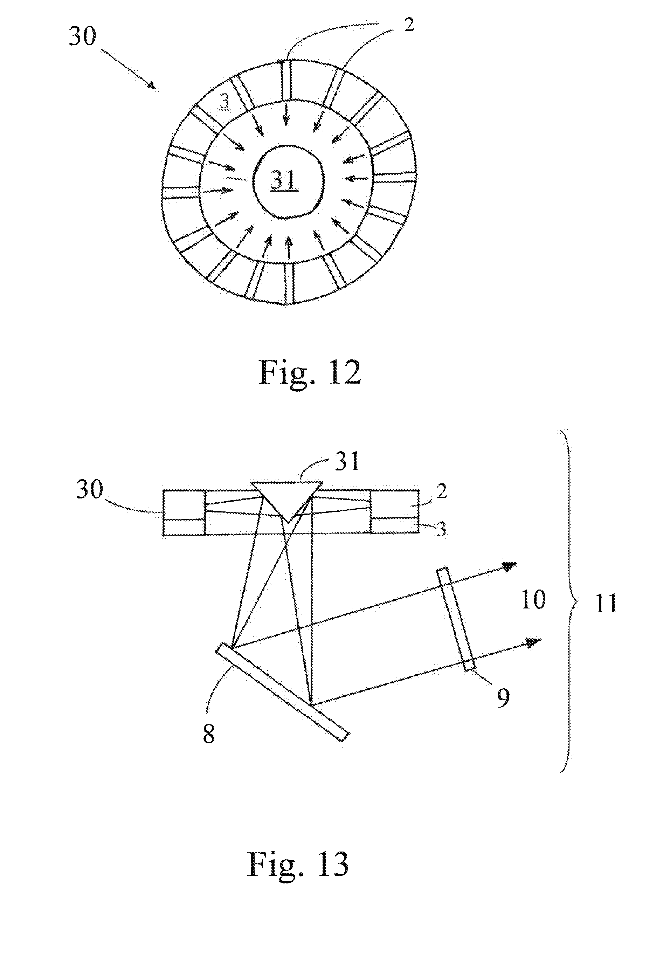

Figur 12 zeigt eine alternative Bauform einer Laserdiodenanordnung 30. Die einzelnen Laserdioden 2 sind hier nicht longitudinal (wie in Fig. 3), sondern entlang eines Kreisumfanges - vorzugsweise voneinander gleichmäßig beabstandet - angeordnet und dabei radial ausgerichtet. Die Laserlicht-Austrittsflächen 4 sind dem Zentrumsbereich des Kreises zugewandt (die Abstrahlungsrichtungen der einzelnen Laserdioden 2 sind in Fig. 12 mit kleinen Pfeilen angedeutet). Bevorzugt sind die Laserdioden 2 wiederum in Form von Plättchen ausgebildet, wobei eine hochkantige Anordnung bzw. Ausrichtung der Laserdioden 2, also mit den Längsausdehnungen L ihrer Laserlicht-Austrittsflächen 4 im Wesentlichen normal zur Aufreihrichtung R bzw. hier zur Umfangsrichtung, - wie anhand Figur 3 beschrieben - besonders vorteilhaft ist. In der Mitte des Kreises befindet sich ein optisches Umlenkelement 31, das die einzelnen Laserdioden-Strahlen in eine gemeinsame Richtung umlenkt.

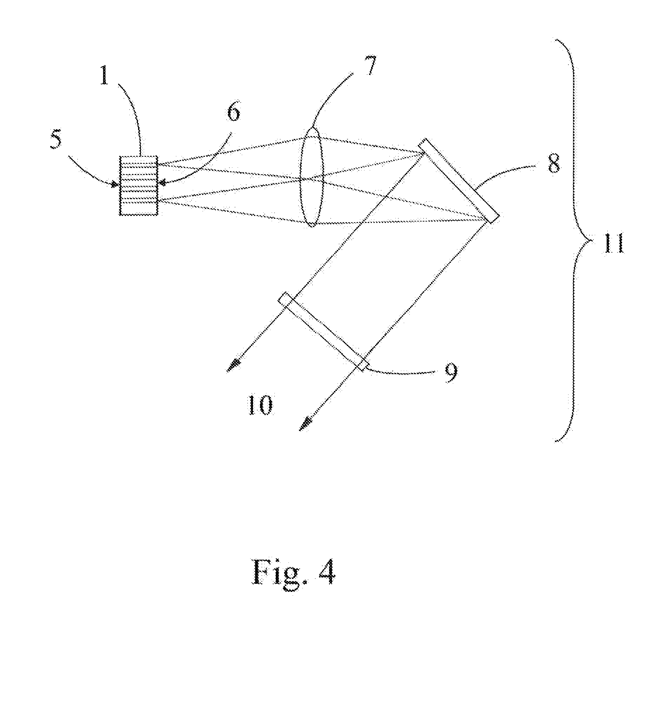

Figur 13 zeigt die Laserdiodenanordnung 30 aus Figur 12 im Schnitt. Darüber hinaus ist an diese Laserdiodenanordnung 30 ein externer Resonator angekoppelt. Der externe Resonator besteht aus dem Umlenkelement 31, einem Beugungsgitter 8 und einem Auskopplungselement 9. Der ausgekoppelte Laserstrahl 10 steht für weitere Konditionierung oder Zusammenführung mit anderen Teilstrahlen zur Verfügung. In ihrer Gesamtheit bilden diese Bauteile ein Lasermodul 11. Die Funktion des externen Resonators wird anhand der Fig. 4 noch eingehender beschrieben.

Das im Zentrum des Kreises angeordnete Umlenkelement 31 kann zum Beispiel in Form eines kegelförmigen Bauteils ausgebildet sein, auf dessen Kegelfläche entsprechend ausgerichtete Spiegel aufgebracht sind.

Anstelle eines kreisförmigen Umfanges sind grundsätzlich alle Arten von Umfängen denkbar, beispielsweise elliptische, ovale, rechteckige, quadratische, Vielecke, etc..

Figur 4 zeigt nun einen weitergehenden Aspekt der vorliegenden Erfindung, nämlich den Einsatz einer Laserdiodenanordnung, z.B. in Form eines Laserdiodenbarrens 1, mit einem externen Resonator. Eine Laserdiodenanordnung mit externem Resonator kann Bestandteil eines Laser-Moduls 11 sein. Der externe Resonator wird durch ein optisches Element 7, zum Beispiel einer (Sammel-)Linse, einem Beugungsgitter 8 ("diffraction grating") und einem Auskopplungselement 9 gebildet. Das optische Element 7 lenkt die einzelnen Laserdioden-Strahlen auf das Beugungsgitter 8, an dem das auftreffende Licht in Abhängigkeit der Wellenlänge abgelenkt und in Richtung Auskopplungselement 9 gerichtet wird. Das Auskopplungselement 9 kann zum Beispiel ein teildurchlässiger Spiegel mit einer reflektierenden Beschichtung sein, die z.B. 10% des Lichtes wieder in Richtung Beugungsgitter 8 reflektiert. Das vom Auskopplungselement 9 reflektierte Licht gelangt über das Beugungsgitter 8 und das optische Element 7 wieder in die Laserdioden 2, wo es verstärkt wird. Das Beugungsgitter 9 ist dabei entsprechend der Laserdiodenanordnung ausgerichtet.

Das Besondere dieser Anordnung besteht darin, dass aufgrund der Geometrie der Resonatorbestandteile in eine einzelne Laserdiode nur mehr Licht einer ganz spezifischen Wellenlänge zurückgelangt. Dies bedeutet das in der betreffenden Laserdiode nur diese eine Wellenlänge verstärkt wird. In den jeweils benachbarten Laserdioden wird jeweils ebenfalls nur eine bestimmte Wellenlänge verstärkt. Die in den einzelnen Laserdioden 2 verstärkten Wellenlängen unterscheiden sich jedoch geringfügig voneinander. Das Beugungsgitter 9 sorgt dafür, dass die Beugungsbedingungen bezüglich der jeweiligen Laserdioden 2 bei verschiedenen Wellenlängen erfüllt ist und dient gleichzeitig der Vereinigung dieser verschiedenen Wellenlängen zu einem Ausgangsstrahl 10. Mit anderen Worten werden die in den einzelnen Laserdioden 2 verstärkten Strahlen durch den Resonator inkohärent addiert.

Kommerziell erhältliche Dioden besitzen üblicherweise eine Verstärkungsbreite (gain oder gain bandwidth) von etwa 50-60 nm. Dies bedeutet, dass eine derartige Laserdiode bei jeder beliebigen Wellenlänge innerhalb dieser Breite verstärkt oder "gelockt" werden kann.

Die Rückseiten 5 der Laserdioden 2 sind mit einer Beschichtung versehen, die einen Großteil des Lichts in die Laserdiode 2 zurückreflektiert (vorzugsweise etwa 99 % oder mehr). An der Vorderseite 6 der Laserdioden 2 ist eine Beschichtung vorgesehen, die nur einen geringen Anteil (üblicherweise etwa 5 %) in die Laserdiode 2 zurückreflektiert. Die Beschichtung auf der Vorderseite 6 der Laserdioden ist für Hochleistungsanwendungen ausgelegt und reduziert die gain auf etwa 4 nm.

Die Erfindung ist nicht auf die Verwendung des in Fig. 4 oder Fig. 13 dargestellten externen Resonators beschränkt, sondern kann mit beliebigen externen Resonatoren ausgeführt werden. In diesem Zusammenhang sei auf die Druckschrift WO 01/35505 A1 verwiesen, die alternative Resonatoren beschreibt und deren Inhalt zur Gänze in diese Beschreibung aufgenommen wird.

Es ist durchaus denkbar, dass in einem Laser-Modul 11 mehrere Laserdiodenbarren zu einem Stapel (stack) vereint sind. Üblicherweise werden die Laserdioden eines

Laserdiodenbarrens elektrisch parallel geschaltet, während die einzelnen Laserdiodenbarren eines Stapels miteinander in Serie geschaltet sind. Das oben anhand der Fig. 4 beschriebene Verfahren wird auch als "Spectral Beam Combining" bezeichnet, weil mehrere, dicht nebeneinander liegende Wellenlängen zu einem gemeinsamen Ausgangsstrahl 10 kombiniert werden.

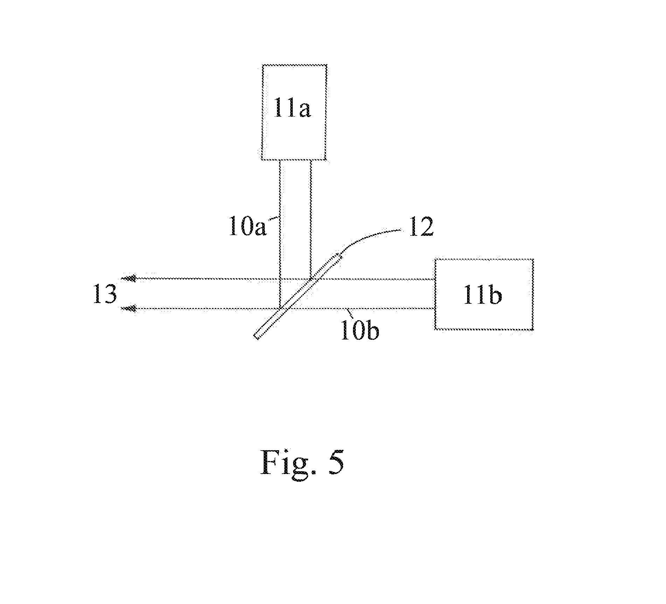

Figur 5 zeigt eine vorteilhafte Ausgestaltung der Erfindung, nämlich ein Lasersystem mit zwei Laser-Modulen 11a und 11 b. Die Laser-Module 11 a, 11b können zum Beispiel den in Figur 4 dargestellten Aufbau haben.

Die von den Laser-Modulen 11a, 11b emittierten Laser-Modul-Ausgangsstrahlen 10a, 10b besitzen unterschiedliche Eigenschaften. In einer Variante können die Laser-Modul-Ausgangsstrahlen 10a, 10b unterschiedliche, vorzugsweise nicht überlappende Spektren aufweisen. Die beiden Strahlen können dann mit einem dichroitischen Spiegel 12 zu einem gemeinsamen Lasersystem-Ausgangsstrahl 13 zusammengeführt werden. Um keine Verluste in der Ausbeute zu generieren, ist es wirklich besonders vorteilhaft, wenn die Spektren der einzelnen Laser-Modul-Strahlen nicht oder nur geringfügig überlappen.

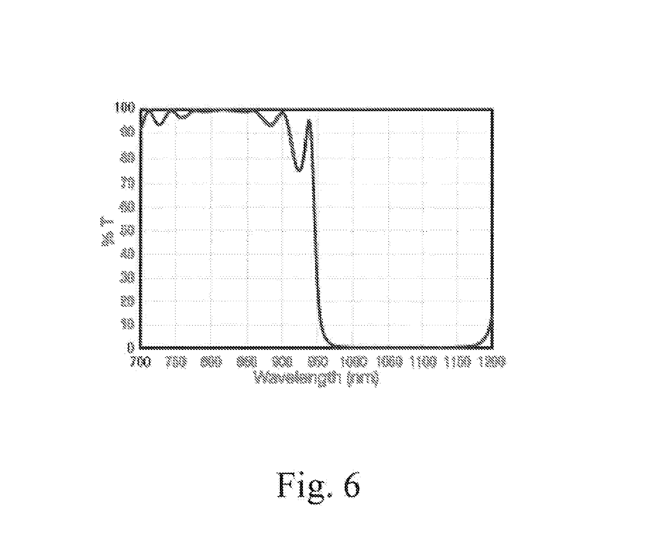

Figur 6 zeigt den Transmissionsverlauf eines dichroitischen Spiegels 12, dessen Flanke bei etwa 960 nm liegt. Als Beispiel kann ein Laser-Modul 11a im Wellenlängenbereich von 1000-1060 nm emittieren und das andere Laser-Modul 11 b im Bereich von 800-860 nm. Mit einem dichroitischen Spiegel entsprechend der Figur 6 lassen sich die beiden breitbandigen Strahlen 10a und 10b gut addieren, ohne dass Lichtleistung verloren geht. Dabei wird der resultierende Lasersystem-Ausgangsstrahl 13 noch breitbandiger als die einzelnen Laser-Modul-Ausgangsstrahlen 10a, 10b, dies stellt jedoch insbesondere in der Laserbearbeitung kein Problem dar.

In einer anderen Variante können sich die Laser-Modul-Ausgangsstrahlen 10a, 10b in ihrer Polarisation unterscheiden. Die Zusammenführung erfolgt in diesem Fall mit einem polarisationsabhängigen Spiegel, der eine Polarisationsrichtung durchlässt, während die er die andere - wie ein Spiegel - reflektiert. Die geometrische Anordnung kann daher jener in Fig. 5 gleichen.

Der große Vorteil dieser Varianten besteht darin, dass zunächst eine inkohärente Addition von eng benachbarten Wellenlängen erfolgt und anschließend eine Addition von Strahlen unterschiedlicher Eigenschaften durch eine StrahlZusammenführungseinrichtung (dichroitischer Spiegel 12 oder Polarisationsspiegel), wodurch in zwei Stufen ein Strahl hoher Leistungsdichte entsteht.

An dieser Stelle sei erwähnt, dass sich selbstverständlich auch mehr als nur zwei Laser-Module 11 miteinander kombinieren lassen mit gegebenenfalls mehreren Zusammenführungseinrichtungen.

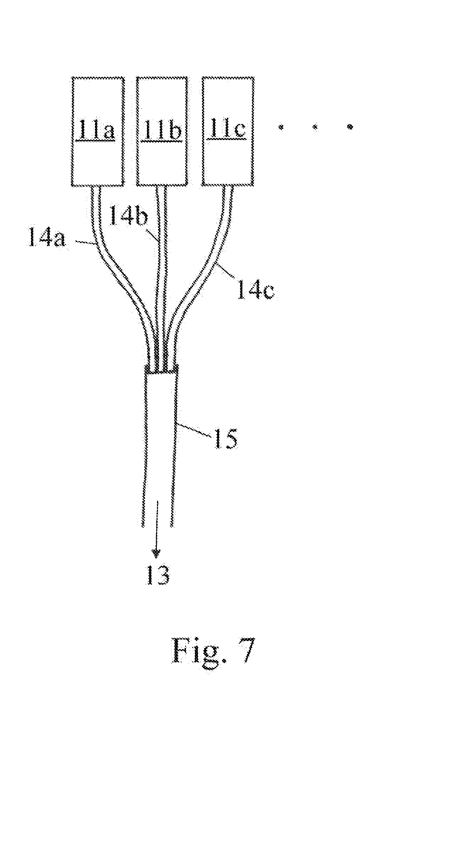

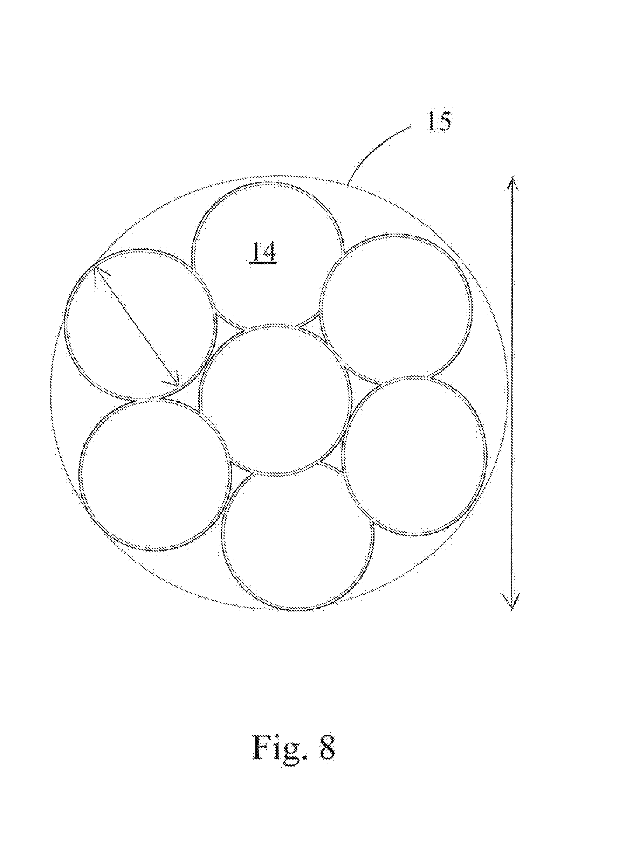

Figur 7 zeigt eine weitere Variante eines Lasersystems, bei dem die Laser-Modul-Ausgangsstrahlen 10a, 10b, 10c in einzelne Lichtleitfasern 14a, 14b, 14c eingekoppelt werden. Um die Strahlen in die Lichtleitfasern zu bündeln, kann eine entsprechende Strahlformungsoptik vorgesehen sein. Die Lichtleitfasern 14a, 14b, 14c münden an einer Anschlussstelle in eine gemeinsame Lichtleitfaser 15 entsprechend höheren Durchmessers. Figur 8 zeigt die Anschlussstelle für ein Beispiel von sieben kleineren Lichtleitfasern 14 mit einer Lichtleitfaser 15 größeren Durchmessers. Die Zusammenführungseinrichtung besteht in diesem Beispiel aus den einzelnen Faser, die an der Anschlussstelle in die gemeinsame Faser münden.

Da mit der Methode des "wavelength beam combining" die Laserstrahlung einer Diodenbarre (mit totaler Leistung bis 150 W) nahezu Single-Mode Qualtität (M² nahezu 1) hat, lässt sich diese in eine Fiber mit Durchmesser < 14 µm (Mikrometer) einkoppeln.

In eine 50 µm Faser, welche typischerweise zum Schneiden eingesetzt wird, lassen sich folglich bis mindestens sieben 14 µm-Fasern von jeweiligen Laser-Modulen einkoppeln. Dies entspricht erneut einer inkohärenten Addition von Laserstrahlung was wiederum bedingt, dass die einzelnen Laser-Module auf unterschiedlichen spektralen Bändern emittieren und die Bänder nicht überlappen.

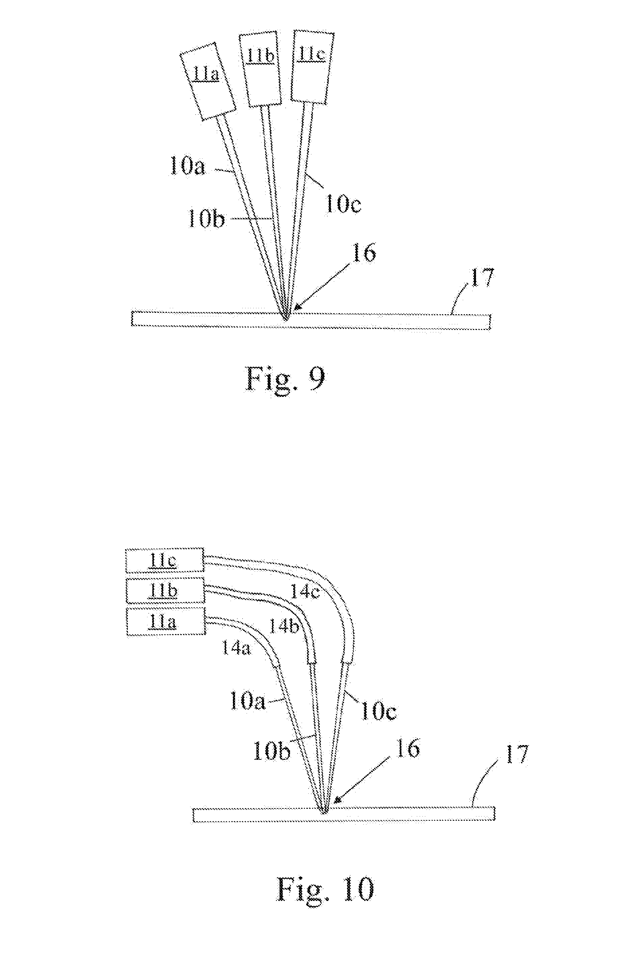

In der Variante der Figur 9 werden die einzelnen Laser-Module 11a, 11b, 11 c eines Lasersystems derart ausgerichtet, dass sich die Laser-Modul-Ausgangsstrahlen 10a, 10b, 10c in einem gemeinsamen Laserspot 16 treffen. Der Laserspot 16 wird in entsprechender Weise so gelegt bzw. positioniert, dass er auf bzw. im zu bearbeitenden Werkstück 17 zu liegen kommt.

Alternativ dazu (siehe Fig. 10) können von den einzelnen Laser-Modulen 11a, 11 b, 11 c einzelne Lichtleitfasern 14a, 14b, 14c mit ihren Laserlicht-Austrittsenden derart ausgerichtet werden, dass sich die Laser-Modul-Ausgangsstrahlen 10a, 10b, 10c ebenfalls in einem gemeinsamen Laserspot 16 treffen.

In den Beispielen der Fig. 9 und 10 ist die Zusammenführungseinrichtung in der speziellen Ausrichtung der Laser-Module oder der Lichtleitfasern gegeben.

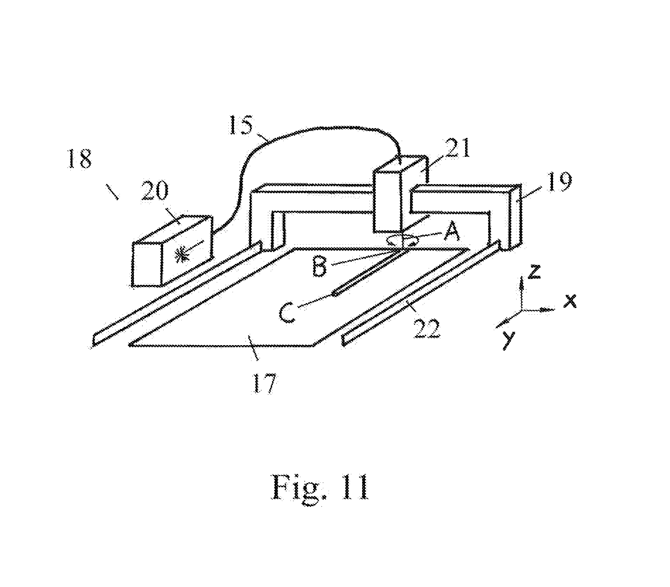

Figur 11 zeigt abschließend in schematischer Darstellung, wie ein erfindungsgemäßes Lasersystem 20 in einer Laserbearbeitungsmaschine 18 integriert sein kann. Ein zu bearbeitendes Werkstücks 17 befindet sich zwischen Führungen 22 für den Laserbearbeitungskopfhalter 19, der darauf verfahrbar eingerichtet ist. Letzterer trägt einen Laserbearbeitungskopf 21, in den das Laserlicht durch eine Lichtleitfaser 15 eingeleitet wird. Das Lasersystem 20 könnte auch im Laserbearbeitungskopf 21 selbst integriert sein.

### Bezugszeichenliste

- 1 -: Laserdiodenbarren
- 2 -: Laserdiode
- 3 -: Trägermatrix
- 4 -: Laserlicht-Austrittsfläche
- 5 -: Rückseite der Laserdiode
- 6 -: Vorderseite der Laserdiode
- 7 -: optisches Element
- 8 -: Beugungsgitter
- 9 -: Auskopplungselement
- 10, 10a, 10b, 10c -: Laser-Modul-Ausgangsstrahl
- 11, 11a, 11b, 11 c -: Laser-Modul
- 12 -: dichroitischer Spiegel
- 13 -: Resonator-Ausgangsstrahl
- 14, 14a, 14b, 14c -: Lichtleitfaser
- 15 -: gemeinsame Lichtleitfaser
- 16 -: Laserspot
- 17 -: Werkstück
- 18 -: Laserbearbeitungsmaschine
- 19 -: Laserkopfhalter
- 20 -: Lasersystem
- 21 -: Laserbearbeitungskopf
- 22 -: Führung
- 30 -: Laserdiodenanordnung
- 31 -: Umlenkelement

## Patentansprüche

1. Laserdiodenanordnung, insbesondere ein Laserdiodenbarren (1), mit einer Trägermatrix (3) und mit in der Trägermatrix (3) eingebetteten, entlang einer Richtung (R) nebeneinander aufgereihten Laserdioden (2), die jeweils im Wesentlichen in Form von Plättchen ausgebildet sind, wobei die auf einer Seite der Laserdiodenanordnung liegenden Stirnflächen der Laserdioden (2) Laserlicht-Austrittsflächen (4) mit einer Längsausdehnung (L) sind, **dadurch gekennzeichnet, dass** die Laserdioden (2) derart ausgerichtet sind, dass die Längsausdehnungen (L) ihrer Laserlicht-Austrittsflächen (4) zur Richtung (R), entlang derer die Laserdioden (2) aufgereiht sind, geneigt sind.

2. Laserdiodenanordnung nach Anspruch 1, **dadurch gekennzeichnet, dass** die Längsausdehnungen (L) der Laserlicht-Austrittsflächen (4) der Laserdioden (2) im Wesentlichen normal zur Richtung (R) stehen, entlang derer die Laserdioden (2) aufgereiht sind.

3. Laserdiodenanordnung (30) mit einer Trägermatrix (3) und mit in der Trägermatrix (3) eingebetteten, nebeneinander angeordneten Laserdioden (2), die Laserlicht-Austrittsflächen (4) aufweisen, **dadurch gekennzeichnet, dass** die Laserdioden (2) entlang eines geschlossenen Umfangs, insbesondere entlang eines Kreises oder einer Ellipse, angeordnet sind.

4. Laserdiodenanordnung nach Anspruch 3, **dadurch gekennzeichnet, dass** die Laserlicht-Austrittsflächen (4) der Laserdioden (2) dem Zentrumsbereich des vom Umfang umschlossenen Gebiets zugewandt sind.

5. Laserdiodenanordnung nach Anspruch 4, **dadurch gekennzeichnet, dass** im Zentrumsbereich des vom Umfang umschlossenen Gebiets ein optisches Umlenkelement (31) sitzt, das die Laserstrahlen der einzelnen Laserdioden (2) in eine gemeinsame Richtung lenkt, wobei das optische Umlenkelement vorzugsweise Teil eines externen Resonators ist.

6. Laserbearbeitungsmaschine, insbesondere zum Schneiden von Werkstücken, **dadurch gekennzeichnet, dass** sie mindestens eine Laserdiodenanordnung (1, 30) nach einem der Ansprüche 1 bis 5 aufweist und dass vorzugsweise die Laserdiodenanordnung (1, 30) an einen externen Resonator angekoppelt ist, der aufgrund seiner optischen Eigenschaften die einzelnen Laserdioden (2) der Laserdiodenanordnung (1, 30) jeweils unterschiedliche Wellenlängen verstärken lässt.

7. Lasersystem (20) zur Erzeugung eines Lasersystem-Ausgangsstrahls (13) oder eines Laserspots (16), umfassend mindestens zwei Laser-Module (11a, 11 b) zur Erzeugung von Laser-Modul-Ausgangsstrahlen (10a, 10b), wobei die Laser-Module (11a, 11 b) jeweils mindestens eine Laserdiodenanordnung, z.B. einen Laserdiodenbarren (1), die nebeneinander angeordnete Laserdioden (2) aufweist, und einen externen Resonator (7, 8, 9), der optisch an die Laserdiodenanordnung angekoppelt ist, umfassen, und wobei das Lasersystem (20) eine Strahlzusammenführungseinrichtung (12; 14,15) aufweist, die die von den Laser-Modulen (11a, 11b) erzeugten Laser-Modul-Ausgangsstrahlen (10a, 10b) zum Lasersystem-Ausgangsstrahl (13) oder Laserspot (16) zusammenführt.

8. Lasersystem (20) nach Anspruch 7, **dadurch gekennzeichnet, dass** sich die Laser-Module (11a, 11b) in der Weise unterscheiden, dass sie Laser-Modul-Ausgangsstrahlen (10a, 10b) unterschiedlicher Eigenschaften erzeugen.

9. Lasersystem (20) nach einem der Ansprüche 7 bis 8, **dadurch gekennzeichnet, dass** die optischen Eigenschaften des externen Resonators (7, 8, 9) die einzelnen Laserdioden (2) einer Laserdiodenanordnung (1, 30) jeweils bei unterschiedlichen Wellenlängen verstärken lassen, wodurch jeweils ein aus verschiedenen Wellenlängen zusammengesetzter Laser-Modul-Ausgangsstrahl (10a, 10b) generierbar ist, und dass der externe Resonator vorzugsweise ein optisches Element (7), ein Beugungsgitter (8) und ein Auskopplungselement (9) aufweist.

10. Lasersystem (20) nach einem der Ansprüche 7 bis 9, **dadurch gekennzeichnet, dass** die Laser-Modul-Ausgangsstrahlen (10a, 10b) der einzelnen Laser-Module (11a, 11b) unterschiedliche, vorzugsweise nicht überlappende Spektren oder unterschiedliche Polarisation aufweisen.

11. Lasersystem nach einem der Ansprüche 7 bis 10, **dadurch gekennzeichnet, dass** in einem Laser-Modul (11a, 11 b) mehrere Laserdiodenbarren (1) enthalten sind und zu einem Stapel zusammengesetzt sind.

12. Lasersystem nach einem der Ansprüche 7 bis 11, **dadurch gekennzeichnet, dass** die Strahlzusammenführungseinrichtung (12) ein dichroitischer Spiegel ist, der entsprechend den unterschiedlichen Spektren der Laser-Modul-Ausgangsstrahlen (10a, 10b) einen Laser-Modul-Ausgangsstrahl (10a) reflektiert und den anderen Laser-Modul-Ausgangsstrahl (10b) hindurchlässt, oder dass die Strahlzusammenführungseinrichtung ein polarisationsabhängiger Spiegel ist, der entsprechend den unterschiedlichen Polarisationen der Laser-Modul-Ausgangsstrahlen (10a, 10b) einen Laser-Modul-Ausgangsstrahl (10a) reflektiert und den anderen Laser-Modul-Ausgangsstrahl (10b) hindurchlässt.

13. Lasersystem nach einem der Ansprüche 7 bis 12, **dadurch gekennzeichnet, dass** die Strahlzusammenführungseinrichtung (14, 15) einzelne Lichtleitfasern (14a, 14b) zur Führung der einzelnen Laser-Modul-Ausgangsstrahlen (10a, 10b) von den Laser-Modulen (11a, 11b) und eine Einmündung in eine gemeinsame Lichtleitfaser (15) umfasst.

14. Lasersystem nach einem der Ansprüche 7 bis 13, **dadurch gekennzeichnet, dass** die Strahlzusammenführungseinrichtung derart ausgebildet ist, dass die einzelnen Laser-Module (11a, 11 b) oder die Enden von den einzelnen Laser-Modulen (11a, 11 b) wegführenden Lichtleitfasern (14a, 14b) derart ausgerichtet sind, dass sich die Laser-Modul-Ausgangsstrahlen (10a, 10b) zu einem Laserspot treffen.

15. Laserbearbeitungsmaschine, insbesondere zum Schneiden von Werkstücken, **dadurch gekennzeichnet, dass** sie ein Lasersystem (20) nach einem der Ansprüche 7 bis 14 aufweist.
